# EUROPEAN PATENT SPECIFICATION

(11) **EP 1 722 617 B1**
(45) Date of publication and mention of the grant of the patent: **21.11.2007**
(21) Application number: 05010296.1
(22) Date of filing: 12.05.2005
(51) Int. Cl.: H05K 7/14

(54) **Electronic device**
Elektronische Vorrichtung
Dispositif électronique

(43) Date of publication of application: 15.11.2006
(73) Proprietor: Harman Becker Automotive Systems GmbH, 76307 Karlsbad (DE)
(72) Inventor: Seifried, Kai, 77815 Brühl (DE)
(74) Representative: Bertsch, Florian Oliver

(56) References cited:
- EP-A- 0 434 192
- EP-A- 0 591 657
- EP-A- 0 654 960
- EP-A- 0 950 570
- GB-A- 2 115 989
- US-A- 4 152 750
- US-A- 4 480 835
- US-A1- 2002 050 384

## Description

This invention relates to an electronic device and to a system and a method for programming a control unit. The invention relates especially to an electronic device which is built in a passenger compartment of a vehicle.

### Related art

In the art, electronic devices are known comprising a main circuit board and a housing in which the main circuit board is fixedly arranged. These electronic devices are incorporated into a dashboard of a vehicle and are often part of a multimedia system incorporated into the vehicle. These multimedia systems often comprise a navigation module for guiding the user to a predetermined destination location, an audio module for reproducing audio data such as CDs, a radio module and/or a telecommunication module. These electronic devices normally comprise one main circuit board having one or two main control units for controlling the functioning of the different modules. During the design of these electronic devices and also at the later stage, it is often necessary to transmit a new software to the electronic device.

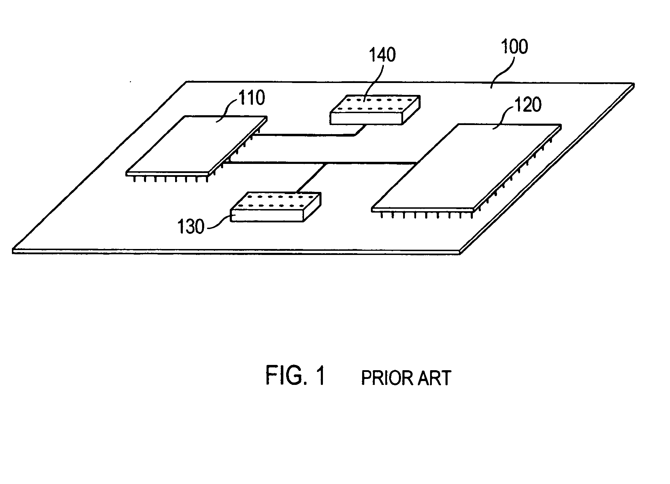

In Fig. 1 a prior art electronic device is shown. The electronic device of the prior art comprises a main circuit board 100 and a first control unit and a second control unit 110, 120. These microprocessors 110, 120 control the functioning of the different operating modes of the electronic device. During the design of the electronic device or also later on, it may be necessary to reconfigure the system or to upload a new software for controlling the electronic device. To this end two update connectors 130, 140 were provided on the main board 100 for connecting a debug interface or any other programming unit providing new data for the two electronic control units 110, 120. If the electronic device comprising the main board 100 was incorporated into the dashboard of a vehicle, this meant that the electronic build-in device had to be removed from the dashboard, and the housing around the main board (not shown) had to be opened in order to access the two update connectors 130, 140. This made the update of the electronic device complicated.

As a consequence, there is a need to provide a possibility to easily access a main circuit board of an electronic device.

US-A-4 152 750 shows an electronic device comprising the prior art features of claim 1.

### Summary of the invention

This need is met by a device as mentioned in the independent claim. In the dependent claims, preferred embodiments of the invention are described.

According to a first aspect of the invention, an electronic device is provided comprising a main circuit board and a housing in which the main circuit board is fixedly arranged. The main circuit board further comprises contact surfaces located on the main circuit board at an edge thereof, wherein the housing further comprises a recess through which a mating connect is connectable to the contact surfaces of the main circuit board by inserting the mating connector into the housing from the outside. The arrangement of the contact surfaces located at an edge of the circuit board relative to the recess helps to facilitate the access to the main circuit board. The contact surfaces are arranged next to the recess provided in the housing, so that the contact surfaces are accessible by a mating connector which is inserted into the housing from the outside. This arrangement of the contact surfaces located on the main board together with the recess in the housing has several advantages: First of all, the main board is accessible from the outside by a mating connector so that the housing has not to be opened for accessing the main board or for accessing any electronic device provided on the main board. Additionally, there is no need any more to provide the update connectors on the main board provided in the prior art as shown in Fig. 1, as the contact surfaces of the update connectors are now provided directly on the surface of the main board. This helps to cut down the costs during the manufacturing of the electronic device, as these update connectors need not to be provided on the main circuit board any more. Additionally, the space needed for the connectors provided on the main circuit board need not to be provided either. The electronic device can be accessed more easily through the recess provided in the housing, so that the electronic device needs not to be removed from a support structure (e.g. the dashboard of a passenger compartment of a vehicle) in which the electronic device may be incorporated. The main circuit board and the electronic device provided on the main circuit board can be addressed by connecting a mating connector through the recess from the outside of the housing.

Preferably, at least one control unit for controlling the operating mode of the electronic device is provided on the main circuit board. The control unit further comprises at least one contact area through which the control unit can be programmed. The control unit needs to have a possibility to upload data to the control unit. These data may comprise a software update or may comprise any other information needed for the functioning of the control unit. According to the invention, the contact area of the control unit is one of the contact surfaces located at the edge of the main circuit board, so that the control unit is programmable by connecting the mating connector to the contact surfaces from the outside of the housing and by transmitting programming data to the control unit. The design of the main circuit board and the contact surfaces provided on the main circuit board is such that the contact surfaces located at the edge of the main board can be used for directly accessing said at least one control unit provided on the main board for a software update or even for the case no programming software at all is provided in the control unit. The new data can be transmitted to the control unit just by connecting the mating connector from the outside to the contact surfaces. The opening of the housing and the removing of the electronic device from the support structure is not necessary any more for connecting a programming unit to the main board.

Preferably, the electronic device further comprises an operating module on a front surface of the device for operating the electronic device. Preferably, the recess is provided on the front surface on which the operating module is also provided. By providing the recess on the same surface as the operating module, it can be assured that the recess can be accessed in all cases, as the operating module for operating the electronic device is normally always accessible to the user of the electronic device. If the operating module is accessible, the recess is also accessible, so that through the recess a meting connector can contact the contact surfaces located at the edge of the main board. The rest of the surfaces of the housing of the electronic device could be hidden by the support structure in which the housing may be arranged.

Preferably, the main circuit board and the recess are located relative to each other in such a way that the housing is a polarizing element preventing the wrong connection of the mating connector to the contact surfaces of the main circuit board. In this embodiment, the contact surfaces are arranged relative to the housing in such a way that the mating connector coming from the outside can only be connected to the main board in one orientation. The connecting of the mating connector in other orientations is prevented and blocked by the housing of the electronic device.

According to the invention, the contact surfaces located at the edge of the main board are directly located on a main surface of the main circuit board. By providing the contact surfaces directly on the main surface, a support structure, such as a connector housing, need not to be provided on the main board.

According to another embodiment of the invention, the contact surfaces are provided on both sides of the main circuit board, i.e. on the upper and the lower side of the circuit board. This helps to provide as many contact surfaces as possible on a predetermined small amount of space of the main circuit board. These contact surfaces can be used for accessing any modules provided on the main circuit board. Preferably, the main circuit board is designed in such a way that the conductive tracks leading from the contact surfaces of the edge of the main board connect all the important components of the main board to the contact surfaces, so that these components can be addressed through the contact surfaces at the edge of the main board.

The description further relates to an update connector adapter comprising an edge connector for contacting contact surfaces provided at an edge of a main circuit board, the adapter further comprising a support structure on which the edge connector is mounted. The adapter further comprises at least another connector mounted to the support structure to which a programming unit is connectable for programming the main circuit board. Preferably, the edge connector is the mating connector mentioned above, which is inserted in the housing of the electronic device through the recess and which contacts the contact surfaces provided at the edge of the main circuit board.

The adapter may further comprise a second connector mounted to the support structure. In this case, the update connector adapter comprises the edge connector and two other connectors. Preferably, these two other connectors are used for connecting update or debug units to the update connector adapter.

Preferably, the support structure further comprises a latch on which the edge connector is provided. The latch is preferably designed in such a way that it fits into the recess of the housing of the electronic device. By inserting the latch into the recess, the edge connector contacts the contact surfaces of the main circuit board.

The invention further relates to a system for programming or updating a control unit of a main circuit board comprising an electronic device as mentioned above, the edge connector being connected to the contact surfaces provided at the edge of the main circuit board. Using this system, the control unit or microprocessor provided on the main board of the electronic device can be updated in a cost-effective way. As new data can be transmitted to the control unit without the need of removing the electronic device from a support structure such as a dashboard, the electronic device can be updated in the mounted state. Furthermore, the housing needs not to be opened to access the control unit. Additionally, update connectors need not to be provided on the main circuit board itself. For programming the control unit of the main circuit board, a programming unit may be connected to at least one of the connectors of the update connector adapter, the programming data being transmitted from the programming unit through one of the connectors of the update connector module to the edge connector of the update connector adapter and finally to the control unit.

The description further relates to a method for programming a control unit of an electronic device comprising the steps of connecting the programming unit to a first connector of an update connector adapter, inserting the update connector adapter into a recess of a housing of the electronic device, connecting an edge connector provided on the update connector adapter to contact surfaces provided at an edge of a main circuit board of the electronic device, the contact surfaces facing the recess. Last but not least, the programming data are transmitted from the programming unit via the update connector adapter to the control unit.

Further embodiments of the invention will now be described in more detail with reference to the accompanying drawings, in which
- Fig. 1: is a schematic view of a main circuit board of the prior art,
- Fig. 2: is a schematic view of a main circuit board which can be used in an electronic device of the invention,
- Fig. 3: shows a part of a main circuit board and the contact surfaces provided at an edge thereof,
- Fig. 4: shows a schematic view of an update connector adapter,

- Fig. 5: shows the update connector adapter of Fig. 4 in connection to the main circuit board, and
- Fig. 6: shows a perspective view of an electronic device having a recess for connecting the update connector adapter.

As already explained in the introductory part of the description, Fig. 1 shows a main circuit board of an electronic device (not shown) of the prior art. In Fig. 1; the update connectors 130 and 140 are provided on the main circuit board 100 for updating the control units 110 and 120.

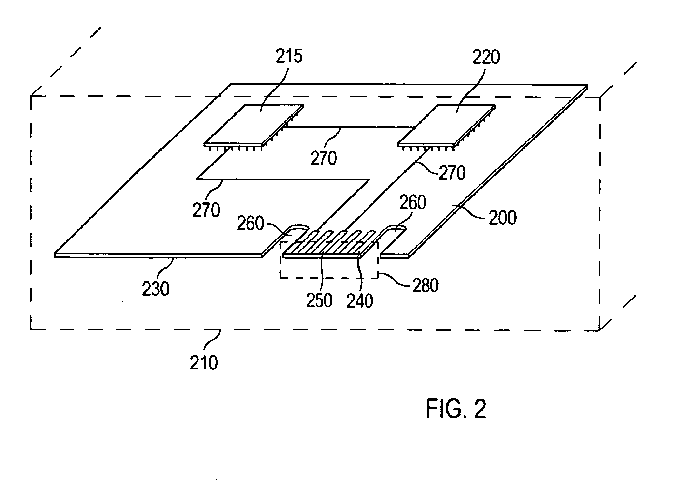

In Fig. 2, a main circuit board 200 of an electronic device is shown according to the invention. The electronic device comprises a housing 210 which is shown in phantom lines. The electronic device may be incorporated into a vehicle or may be incorporated into any other support structure supporting the housing of the electronic device. The main circuit board 200 comprises a first control unit 215 connected to the main board 200 and a second control unit 220 connected to the main board 200. It should be understood that the main board 200 can comprise many other electronic components, but they were omitted for the sake of clarity.

The main circuit board 200 comprises at one of its edges 230 a cantilevered portion or blade 240 on which contact surfaces 250 are provided. At its front end, the blade 240 is separated from the rest of the main board 200 by two cut-outs 260 which receive a mating connector, as will be explained in detail later on.

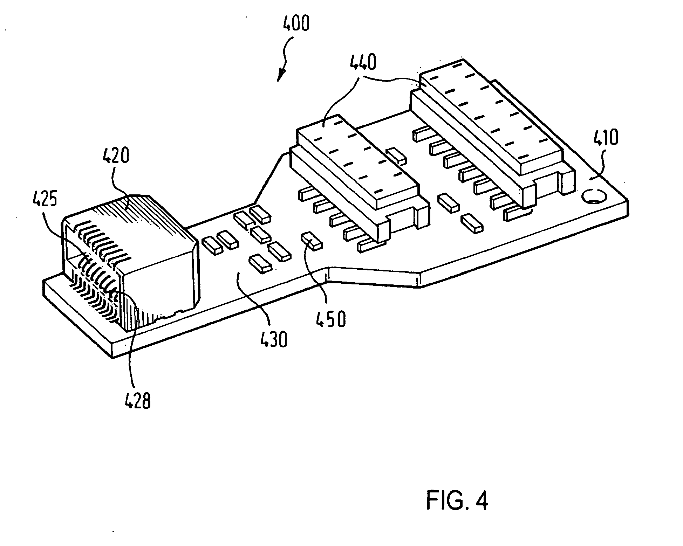

On the main board, circuit board tracks 270 are provided which connect the contact surfaces 250 to the control units 215 and 220. In the housing 210 of the electronic device, a recess 280 is provided at a location facing the contact surfaces 250, so that a mating connector (as shown in Fig. 4) may be introduced into the housing for contacting the contact surfaces 250.

The contact surfaces 250 are provided on the main board and are connected to the control units 115 and 120 in such a way that programming data such as a new software for the control units 110, 120 can be uploaded. Additionally, a debugging unit may be connected to the two control units 110, 120 via the contact surfaces 250 to find a protocol of a faulty operation of the electronic device.

When comparing Fig. 1 to Fig. 2, it can be noted that the two update connectors 130, 140 need not to be provided on the main board 200 any more, this leaving more free space for other electronic components, this also contributing to a cost-effective manufacturing of the electronic device, as the two connectors can be omitted.

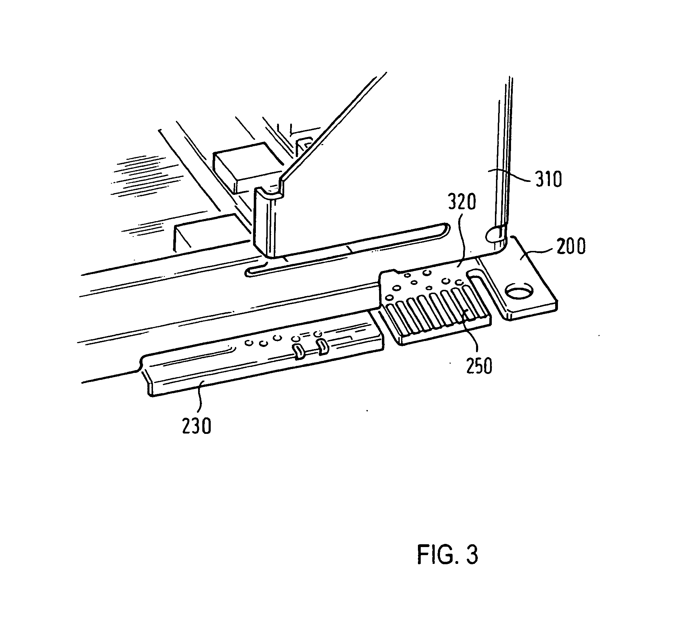

In Fig. 3, part of the main circuit board 200 is shown, the housing of the electronic device being omitted for the sake of clarity. In the embodiment of Fig. 3, the main circuit board is shown together with a frame 310 which is provided in the electronic device which helps to support the different electronic modules provided in the electronic device relative to each other. The electronic device may be a head unit of a vehicle, comprising different electronic modules such as a navigation module, an audio module, a telecommunication module and/or a radio module. All of these modules are controlled by the main circuit board 200. The frame 310 comprises above the contact surfaces 250 a cutout section 320 in order to facilitate the inserting of a mating connector.

In Fig. 4, an update connector adapter 400 is shown. The adapter 400 comprises a support structure on which an edge connector 420 is provided on a latch 430 of the support structure 410. The edge connector 420 is a connector socket having a large opening 425 for receiving the cantilevered part 240 of the main circuit board 200. Additionally, contact terminals 428 are provided in the edge connector contacting the contact surfaces 250. The contact terminals 428 may be provided on the upper and the lower part of the housing of the edge connector 420, so that contact surfaces 250 provided on both surfaces of the main circuit board can be contacted. These edge connectors are known to the person skilled in the art, so that a detailed description of the edge connector can be omitted.

Additionally, on the support structure there are provided two update connectors 440. These update connectors may correspond to the update connectors 130, 140 provided directly on the main circuit board of the prior art. However, any other update connectors may be used. These update connectors can be used for connecting a programming unit such as a user debug interface or any device for uploading data to the control units 215, 220. Connectors such as the two connectors 440 are known in the art, so that a detailed description of the connectors is omitted. Additionally, on the support structure 410, resistors 450 may be provided for adapting the voltage from a programming unit to the voltage supplied to the control unit on the main circuit board 200. In the update connector adaptor 400 tracks (not shown) are provided for connecting the contact terminals of the two update connectors 440 to the contact terminals of the edge connector 420. As can be seen in Fig. 4, the two update connectors need only to be provided on the update connector adapter, but they need not to be provided on the main circuit board itself.

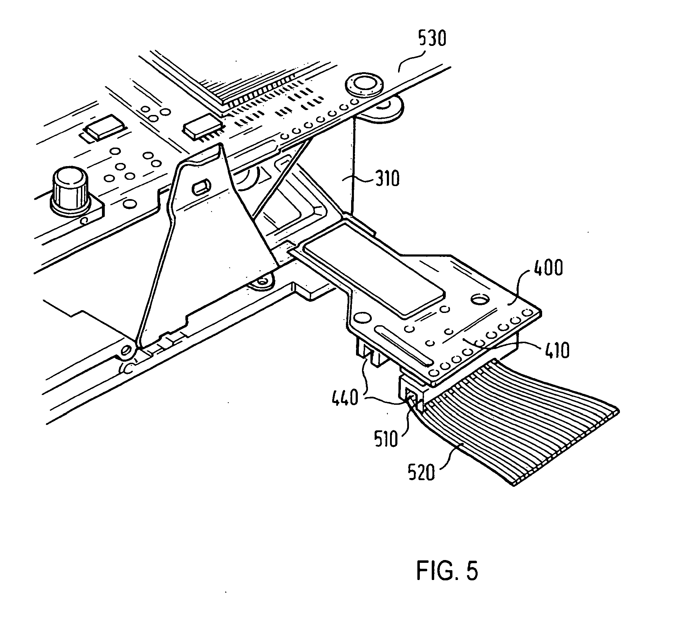

In Fig. 5, the update connector adapter 400 is shown in its connected state, when it is connected to the contact surfaces 250 of the main circuit board 200. In the embodiment shown, the update connector adapter 400 is in a position with the support structure 410 on the upper side, the two update connectors 440 being on the lower side. Additionally, a complementary connector 510 is shown connected to one of the update connectors 440 and the edge connector 420 is slided onto the cantilevered part 240 of the main circuit board 200, the contact elements 428 of the edge connector 420 contacting the contact surfaces 250 provided either on one of the surfaces or on both of the surfaces of the main circuit board 200. In the connected state shown in Fig. 5, programming data can be transmitted from a programming unit (not shown) via the ribbon cable 520 through one of the update connectors 440, through the edge connector 420 and the contact surfaces 250 to the control units 215, 220.

In the embodiment shown in Fig. 5, a tuner circuit board 530 is connected to the frame 310 indicating that the electronic device may comprise different electronic modules.

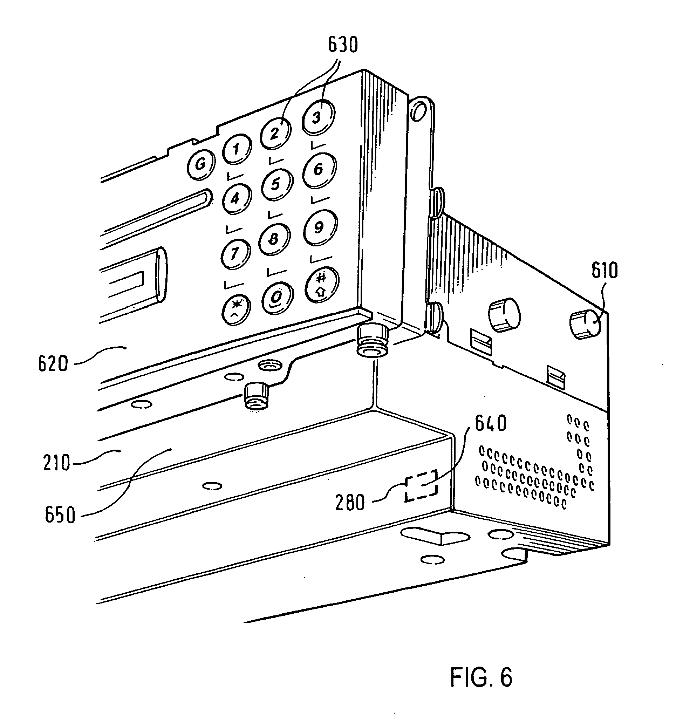

In Fig. 6, the housing 210 of the electronic device is shown in a perspective view. The electronic device may be incorporated into a support structure such as a dashboard of a vehicle using mounting pegs 610, which are arranged at the side surfaces of the housing. On the front part of the housing 210, an operating module 620 may be provided comprising different operating buttons 630 which can be used for the different operating modes of the electronic device. The front surface 650 faces the passenger compartment of the vehicle, when the housing is incorporated into a support structure. The recess 280 is also provided on the front surface 650 of the housing, allowing an easy access of the update connector adapter 400, shown in Figs. 4 and 5, even in the mounted state of the housing.

In the mounted state of the housing, the control units of the device can be configured or updated in an easy way, a programming unit can be connected to one of the connectors of the update connector adapter, the update connector adapter can be inserted into the recess 280 of the housing, and the edge connector provided on the update connector adapter can be connected to the contact surfaces provided on the main circuit board.

In the embodiment shown in Fig. 6, the recess 280 is shown covered by a plate 640. If the recess is not used, the opening of the recess 280 should be covered for shielding the electronic device. If programming data need to be transmitted to the control unit, the plate may be removed or bend in such a way that the edge connector 230 can be inserted through the recess 280. When the update connector adapter is removed, the plate 640 should again cover the recess. It is also possible to use an adhesive tape having shielding properties to protect the recess when the latter is not is use.

In conclusion, the invention provides a possibility for programming a control unit provided in an electronic device in an easy way. Even if the electronic device does not work at all, by way of example, if no software at all is provided in the electronic device for running the latter, this software can be transmitted to the contact surfaces through the recess provided in the housing. Additionally, the main circuit board of the electronic device need not to provide space for accommodating the update connectors, which are moved to the outside and which are provided on the update connector adapter.

## Claims

1. Electronic device comprising a main circuit board (200) and a housing (210) in which the main circuit board is fixedly arranged, the main circuit board further comprising contact surfaces (250) located on the main circuit board at an edge thereof, wherein the housing further comprises a recess (280) through which a mating connector (420) is connectable to the contact surfaces (250) of the main circuit board by inserting the mating connector into the housing from the outside, **characterized in that** the electronic device is suitable as a built-in electronic device for a vehicle and mountable on a passenger compartment of the vehicle, wherein the recess for introducing the mating connector is situated on a front surface of the housing (210) facing the passenger compartment, wherein the contact surfaces (250) are directly located on a main surface of the main circuit board (200).

2. Device according to claim 1, **characterized in that** at least one control unit (215, 220) for controlling the operating mode of the electronic device is provided on said main circuit board (200), the control unit having at least one contact area through which the control unit can be programmed, wherein the contact area is one of the contact surfaces (250) located at the edge of the main circuit board, so that the control unit (215, 220) is programmable by connecting the mating connector (420) to the contact surfaces and by transmitting programming data to the control unit from the outside of the housing.

3. Device according to claim 1 or 2, **characterized by** further comprising an operating module (620) on a front surface (630) of the device for operating the electronic device, wherein the recess (280) is provided on the front surface.

4. Device according to any of the preceding claims, **characterized in that** the main circuit board (200) and the recess (280) are located relative to each other in such a way, that the housing (210) is a polarizing element preventing the wrong connection of the mating connector (420) to the contact surfaces of the main circuit board.

5. Device according to any of the preceding claims, **characterized in that** the contact surfaces (250) are directly located on opposite surfaces of the main circuit board (200).

6. System for programming a control unit of a main circuit board, comprising an electronic device as claimed in any of claims 1 to 5, an update connector adapter (400) comprising an edge connector for contacting the contact surfaces provided at the edge of the main circuit board, wherein the edge connector (420) is connected to the contact surfaces (250) at the edge of the main circuit board (200).

7. System according to claim 6, **characterized in that** a programming unit is connected to said at least one connector of the update connector adapter for programming the control unit on the main circuit board.

## Patentansprüche

1. Elektronische Vorrichtung, welche eine Hauptplatine (200) und ein Gehäuse (210), in welchem die Hauptplatine ortsfest angeordnet ist, umfasst, wobei die Hauptplatine ferner Kontaktflächen (250) umfasst, welche an der Hauptplatine an einem Rand davon angeordnet sind, wobei das Gehäuse ferner eine Aussparung (280) umfasst, durch welche ein passender Verbinder (420) mit den Kontaktflächen (250) der Hauptplatine durch Einsetzen des passenden Verbinders von der Außenseite in das Gehäuse verbindbar ist,
**dadurch gekennzeichnet,**
**dass** die elektronische Vorrichtung als eine eingebaute elektronische Vorrichtung für ein Fahrzeug geeignet ist und an einem Insassenabteil des Fahrzeugs anbringbar ist, wobei die Aussparung zum Einführen des passenden Verbinders an einer Vorderfläche des Gehäuses (210) gegenüberliegend dem Insassenabteil angeordnet ist, wobei die Kontaktflächen (250) direkt an einer Hauptfläche der Hauptplatine (200) angeordnet sind.

2. Vorrichtung nach Anspruch 1, **dadurch gekennzeichnet, dass** mindestens eine Steuereinheit (215, 220) zum Steuern der Betriebsart der elektronischen Vorrichtung auf der Hauptplatine (200) vorgesehen ist, wobei die Steuereinheit mindestens einen Kontaktbereich aufweist, über welchen die Steuereinheit programmiert werden kann, wobei der Kontaktbereich eine der Kontaktflächen (250), welche an dem Rand der Hauptplatine angeordnet sind, ist, so dass die Steuereinheit (215, 220) durch Verbinden des passenden Verbinders (420) mit den Kontaktflächen und durch Übertragen von Programmierdaten von der Außenseite des Gehäuses zu der Steuereinheit programmierbar ist.

3. Vorrichtung nach Anspruch 1 oder 2, **dadurch gekennzeichnet, dass** sie ferner eine Bedienfunktionseinheit (620) an einer Vorderfläche (630) der Vorrichtung zum Bedienen der elektronischen Vorrichtung umfasst, wobei die Aussparung (280) an der Vorderfläche vorgesehen ist.

4. Vorrichtung nach einem der vorhergehenden Ansprüche, **dadurch gekennzeichnet, dass** die Hauptplatine (200) und die Aussparung (280) relativ zueinander derartig angeordnet sind, dass das Gehäuse (210) ein polarisierendes Element ist, welches die falsche Verbindung des passenden Verbinders (420) mit den Kontaktflächen der Hauptplatine verhindert.

5. Vorrichtung nach einem der vorhergehenden Ansprüche, **dadurch gekennzeichnet, dass** die Kontaktflächen (250) direkt an gegenüberliegenden Flächen der Hauptplatine (200) angeordnet sind.

6. System zum Programmieren einer Steuereinheit einer Hauptplatine, welches eine elektronische Vorrichtung nach einem der Ansprüche 1-5 umfasst, wobei ein Aktualisierungsverbindungsadapter (400) einen Randverbinder zum Verbinden der Kontaktflächen, welche an dem Rand der Hauptplatine vorgesehen sind, umfasst, wobei der Randverbinder (420) mit den Kontaktflächen (250) an dem Rand der Hauptplatine (200) verbunden ist.

7. System nach Anspruch 6, **dadurch gekennzeichnet, dass** eine Programmiereinheit mit dem mindestens einen Verbinder des Aktualisierungsverbindungsadapters zum Programmieren der Steuereinheit der Hauptplatine verbunden ist.

## Revendications

1. Dispositif électronique comprenant une carte principale de circuit imprimé (200) et un boîtier (210) dans lequel la carte principale de circuit imprimé est agencée de manière fixe, la carte principale de circuit imprimé comprenant en outre des surfaces de contact (250) situées sur la carte principale de circuit imprimé au niveau d'un bord de celle-ci, dans lequel le boîtier comprend en outre un évidement (280) à travers lequel un connecteur d'accouplement (420) peut être connecté aux surfaces de contact (250) de la carte principal de circuit imprimé par insertion du connecteur d'accouplement dans le boîtier depuis l'extérieur, **caractérisé en ce que** le dispositif électronique est approprié en tant que dispositif électronique intégré pour un véhicule et peut être monté dans un compartiment passager du véhicule, dans lequel l'évidement destiné à introduire le connecteur d'accouplement est situé sur une surface avant du boîtier (210) face au compartiment passager, dans lequel les surfaces de contact (250) sont directement situées sur une surface principale de la carte principale de circuit imprimé (200).

2. Dispositif selon la revendication 1, **caractérisé en ce que** au moins une unité de commande (215, 220) destinée à commander le mode de fonctionnement du dispositif électronique est prévue sur ladite carte principale de circuit imprimé (200), l'unité de commande ayant au moins une zone de contact à travers laquelle l'unité de commande peut être programmée, dans lequel la zone de contact est l'une des surfaces de contact (250) situées au niveau du bord de la carte principale de circuit imprimé, de telle sorte que l'on puisse programmer l'unité de commande (215, 220) en connectant le connecteur d'accouplement (420) aux surfaces de contact et en transmettant des données de programmation à l'unité de commande depuis l'extérieur du boîtier.

3. Dispositif selon la revendication 1 ou 2, **caractérisé en ce qu'**il comprend en outre un module de fonctionnement (620) sur une surface avant (630) du dispositif pour faire fonctionner le dispositif électronique, dans lequel l'évidement (280) est prévu sur la surface avant.

4. Dispositif selon l'une quelconque des revendications précédentes, **caractérisé en ce que** la carte principale de circuit imprimé (200) et l'évidement (280) sont situés l'une par rapport à l'autre de telle sorte que le boîtier (210) soit un élément polarisant empêchant la mauvaise connexion du connecteur d'accouplement (420) aux surfaces de contact de la carte principale de circuit imprimé.

5. Dispositif selon l'une quelconque des revendications précédentes, **caractérisé en ce que** les surfaces de contact (250) sont situées directement sur des surfaces opposées de la carte principale de circuit imprimé (200).

6. Système destiné à programmer une unité de commande d'une carte principale de circuit imprimé, comprenant un dispositif électronique selon l'une quelconque des revendications 1 à 5, un adaptateur (400) de connecteur de mise à jour comprenant un connecteur latéral destiné à venir en contact avec les surfaces de contact disposées au niveau du bord de la carte principale de circuit imprimé, dans lequel le connecteur latéral (420) est connecté aux surfaces de contact (250) au niveau du bord de la carte principale de circuit imprimé (200).

7. Système selon la revendication 6, **caractérisé en ce qu'**une unité de programmation est connectée audit au moins un connecteur de l'adaptateur du connecteur de mise à jour pour programmer l'unité de commande sur la carte principale de circuit imprimé.
